(19) **Europäisches Patentamt**

**European Patent Office**

**Office européen des brevets**

(11) **EP 1 338 012 B1**

(12) **EUROPÄISCHE PATENTSCHRIFT**

(45) Veröffentlichungstag und Bekanntmachung des Hinweises auf die Patenterteilung:
**20.07.2005 Patentblatt 2005/29**

(21) Anmeldenummer: **01998974.8**

(22) Anmeldetag: **16.11.2001**

(51) Int Cl.$^7$: **G11C 11/16**

(86) Internationale Anmeldenummer:
**PCT/DE2001/004312**

(87) Internationale Veröffentlichungsnummer:
**WO 2002/045090 (06.06.2002 Gazette 2002/23)**

(54) **SCHALTUNGSANORDNUNG ZUM ZERSTÖRUNGSFREIEN, SELBSTNORMIERENDEN AUSLESEN VON MRAM-SPEICHERZELLEN**

CIRCUIT FOR NON-DESTRUCTIVE, SELF-NORMALIZING READING-OUT OF MRAM MEMORY CELLS

CIRCUIT DESTINE A LA LECTURE NON DESTRUCTRICE ET A NORMALISATION AUTOMATIQUE DE CELLULES DE MEMOIRE MRAM

(84) Benannte Vertragsstaaten:
**DE FR GB IE IT**

(30) Priorität: **29.11.2000 DE 10059182**

(43) Veröffentlichungstag der Anmeldung:
**27.08.2003 Patentblatt 2003/35**

(73) Patentinhaber: **Infineon Technologies AG
81669 München (DE)**

(72) Erfinder:
• **HOFFMANN, Kurt
82024 Taufkirchen (DE)**
• **KOWARIK, Oskar
85579 Neubiberg (DE)**

(74) Vertreter: **Kottmann, Heinz Dieter, Dipl.-Ing.
Patentanwälte
MÜLLER & HOFFMANN,
Innere Wiener Strasse 17
81667 München (DE)**

(56) Entgegenhaltungen:
• **Keine einschlägigen Dokumente gefunden**

EP 1 338 012 B1

**Beschreibung**

Die Erfindung betrifft einen MRAM Speicher mit einer Schaltungsanordnung zum zerstörungsfreien, selbstnormierenden Auslesen von MRAM-Speicherzellen (MRAM = magnetoresistiver RAM) nach dem Oberbegriff des Patentanspruches 1.

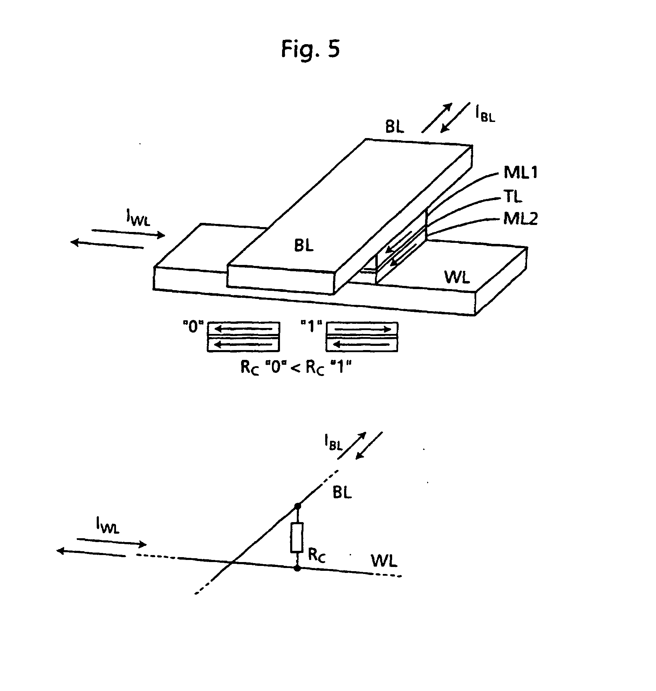

Eine Speicherzelle eines MRAMs ist schematisch in Fig. 5 gezeigt. In einer solchen Speicherzelle wird die zu speichernde Information durch die Art der Ausrichtung der magnetischen Momente in benachbarten magnetisierten Schichten ML1 und ML2, die voneinander durch eine sehr dünne, nicht magnetische und nicht leitende Zwischenschicht TL getrennt sind, abgespeichert. Die Größe des elektrischen Widerstandes über der Speicherzelle hängt nämlich von der parallelen oder antiparallelen Ausrichtung der magnetischen Momente in den magnetisierten Schichten ML1 und ML2, also deren Polarisation ab. Bei paralleler Ausrichtung der magnetischen Momente in den beiden Schichten ML1 und ML2 ist der Widerstandswert der Speicherzelle in der Regel niedriger als bei deren antiparalleler Ausrichtung. Dieser Effekt wird auch als TMR-Effekt (TMR = "tunneling magneto-resistive") oder als MTJ-Effekt (MTJ = "magnetic tunnel junction") bezeichnet. Eine Speicherzelle aus den Schichten ML1, TL und ML 2 ist daher auch unter dem Namen MTJ-Zelle bekannt.

Damit kann der Speicherinhalt der Speicherzelle durch die Detektion des für eine "1" bzw. "0" unterschiedlichen Widerstandswertes der Speicherzelle ausgelesen werden. Eine parallele Magnetisierung der beiden Schichten ML1 und ML2 kann beispielsweise einer digitalen Null zugeordnet werden, wobei dann die antiparallele Magnetisierung dieser Schichten einer digitalen Eins entspricht.

Die Widerstandsänderung zwischen einer parallelen und antiparallelen Ausrichtung der magnetischen Momente in den magnetisierten Schichten ML1 und ML2 beruht physikalisch auf der Wechselwirkung der Elektronenpins der Leitungselektronen in der dünnen nichtmagnetischen Zwischenschicht TL mit den magnetischen Momenten in den magnetisierten Schichten ML1 und ML2 der Speicherzelle. Durch "dünn" soll hier zum Ausdruck gebracht werden, daß die Leitungselektronen die Zwischenschicht TL ohne Spin-Streuprozesse durchqueren können.

Vorzugsweise ist eine der beiden magnetisierten Schichten ML1 und ML2 mit ihrer Magnetisierung an eine antiferromagnetische Unterlage oder Deckschicht gekoppelt, wodurch die Magnetisierung in dieser magnetisierten Schicht im wesentlichen fixiert bleibt, während die andere magnetisierte Schicht schon bei kleinen Magnetfeldern, wie sie etwa durch einen Strom in einer Wortleitung WL und einer Bitleitung BL über und unter dieser magnetisierten Schicht erzeugt werden, in ihrem magnetischen Moment frei ausgerichtet werden kann.

In einem Speicherzellenfeld werden Programmierströme $I_{WL}$ und $I_{BL}$ durch die Wortleitung WL bzw. durch die Bitleitung BL so gewählt, daß nur in der Zelle, in welcher sich die Wortleitung WL mit der Bitleitung BL kreuzt, durch die Summe der beiden Ströme $I_{WL}$ und $I_{BL}$ ein zur Programmierung ausreichend starkes Magnetfeld herrscht, während alle anderen an dieser Wortleitung WL bzw. dieser Bitleitung BL liegenden Speicherzellen von dem nur durch eine dieser beiden Leitungen fließenden Strom nicht umprogrammiert werden können.

In der unteren Hälfte von Fig. 5 ist nochmals der Widerstand $R_C$ der Speicherzelle zwischen einer Bitleitung BL und einer Wortleitung WL schematisch veranschaulicht, wobei dieser Widerstand $R_C$ für antiparallele Ausrichtung der magnetischen Momente in den Schichten ML1 und ML2 größer ist als für parallele Ausrichtung dieser magnetischen Momente, d.h. $R_C$ ("0") < $R_C$ ("1"), wenn die obige Annahme für die Zuordnung von "1" bzw. "0" zugrundegelegt wird.

In ihrer einfachsten Ausführungsform haben MRAMs sich matrixförmig kreuzende Leiterbahnen für die Wortleitungen WL und die Bitleitungen BL, über die die Speicherzellen angesteuert werden. Eine obere Leiterbahn, beispielsweise die Bitleitung BL (vgl. Fig. 5), ist dabei mit der oberen magnetisierten Schicht ML1, z. B. einer Ferromagnetschicht, verbunden, während die untere Leiterbahn, die die Wortleitung WL bildet, an der unteren magnetisierten Schicht ML2, bei der es sich ebenfalls um eine ferromagnetische Schicht handeln kann, anliegt. Wird über die beiden Leiterbahnen für die Wortleitung WL bzw. die Bitleitung BL eine Spannung an die Speicherzelle angelegt, so fließt ein Tunnelstrom durch die dünne nichtmagnetische Zwischenschicht TL. Durch diese dünne nichtmagnetische Zwischenschicht wird dann der Widerstand $R_C$ gebildet, der abhängig von der parallelen oder antiparallelen Ausrichtung der magnetischen Momente, also der parallelen oder antiparallelen Polarisierung der oberen und unteren Ferromagnetschicht ML1 bzw. ML2 bei geeigneter Spannung über der Speicherzelle die Größe $R_C$ ("0") < $R_C$ ("1") bzw. $R_C$ ("1") = $R_C$ ("0") + $\Delta R_C$ annimmt.

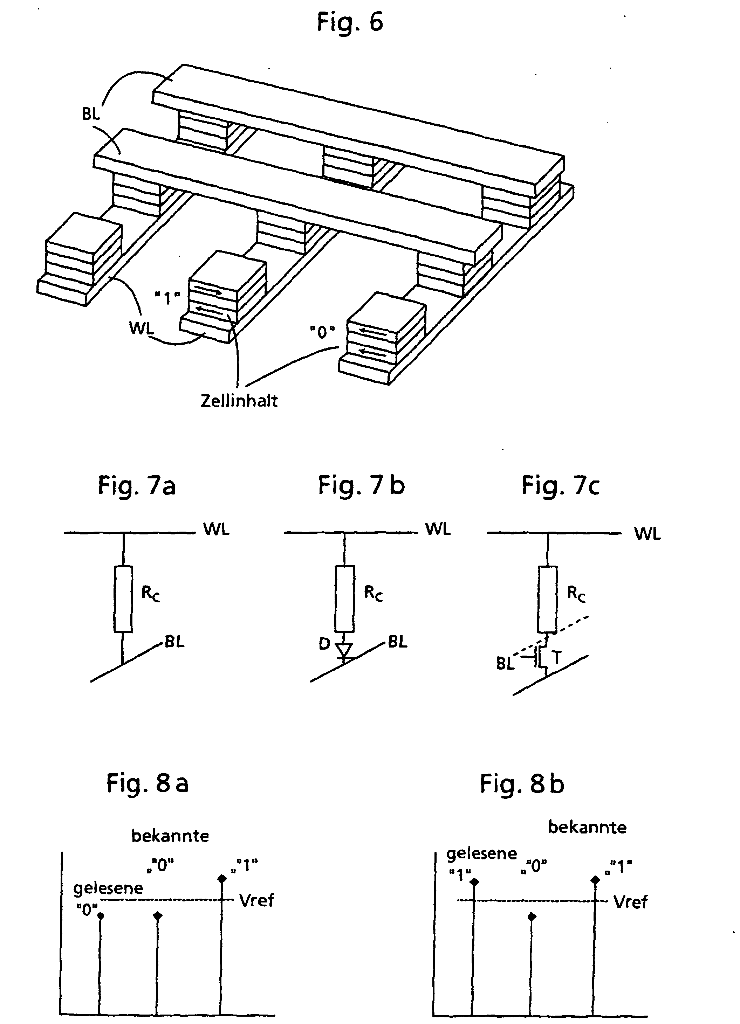

Fig. 6 zeigt ein Speicherzellenfeld, in welchem Speicherzellen matrixartig an Kreuzungsstellen zwischen Wortleitungen WL und Bitleitungen BL angeordnet sind.

Der Zellinhalt ist hier schematisch abhängig von der antiparallelen oder parallelen Polarisierung als "1" bzw. "0" für zwei Speicherzellen angedeutet.

In einem Speicherzellenfeld, wie dieses in Fig. 6 gezeigt ist, fließt nun ein Strom nicht nur über die Speicherzelle an der Kreuzungsstelle zwischen einer ausgewählten Wortleitung WL und einer ausgewählten Bitleitung BL, sondern es treten unerwünschte Nebenströme auch an weiteren Speicherzellen auf, die jeweils mit der ausgewählten Wortleitung WL bzw. der ausgewählten Bitleitung BL verbunden sind. Diese unerwünschten Nebenströme stören erheblich den Lesestrom, der durch die ausgewählte Speicherzelle fließt.

Es wurden daher bereits Anstrengungen unternommen, durch geeignete Beschaltung des Speicherzellenfeldes solche unerwünschten Nebenströme vom Lesestrom weitgehend zu separieren, so daß nur der Lesestrom durch die ausgewählte Speicherzelle bzw. die Lesespannung über dieser Speicherzelle zur Detektion zur Verfügung steht. Dabei muß aber der Widerstandswert der Speicherzellen wegen der parasitären Ströme durch die anderen Speicherzellen hoch und insbesondere im MOhm-Bereich gewählt werden, um ausreichend große Speicherzellenfelder aufbauen zu können.

Ein anderer Weg, um die unerwünschten Nebenströme zu vermeiden, besteht darin, die an sich einfach aufgebaute MTJ-Speicherzelle (vgl. Fig. 7a) um eine Diode D (vgl. Fig. 7b) oder um einen Schalttransistor T (vgl. Fig. 7c) zu erweitern (R. Scheuerlein e.a., "A 10ns Read and Write Time Non-Volatile Memory Array Using a Magnetic Tunnel Junction and FET-Switch in each Cell", ISSCC Feb. 2000 S. 128/R.c. Sousa e.a., "Vertical Integration of a spin dependent tunnel junction with an amorphous Si diode", appl. Phys. Letter Vol. 74, Nr. 25, S. 3893 bis 3895).

Der Vorteil einer solchen Erweiterung um eine Diode D bzw. einen Schalttransistor T liegt darin, daß im Speicherzellenfeld bei einer solchen Beschaltung nur ein Lesestrom durch die jeweils ausgelesene Speicherzelle fließt, da alle übrigen Speicherzellen gesperrt sind. Dadurch kann der Widerstandswert der Speicherzelle im Gegensatz zu einer reinen MTJ-Zelle entsprechend Fig. 7a niedriger gewählt werden, wodurch der Lesestrom relativ groß wird und das Auslesen schnell im ns-Bereich erfolgen kann. Nachteilhaft an einer solchen zusätzlichen Beschaltung mit einer Diode bzw. einem Transistor ist aber der dadurch bedingte erhebliche zusätzliche Technologie- und Flächenaufwand.

Beim derzeitigen Stand der Technik ist allen Speicherzellentypen gemeinsam, daß die Detektion bzw. Bewertung eines Lesesignales als "0" oder "1" sehr schwierig ist, da der durch die Schichtenfolge der Schichten ML1, TL und ML2 gebildete Tunnelwiderstand in der Regel nicht nur über einen Wafer hinweg, sondern sogar in vielen Fällen zwischen benachbarten Speicherzellen sehr viel stärker, d.h. bis zu 40 %, schwankt als der Unterschied des Widerstands $\Delta R_C$ zwischen einem "1"-Zustand und einem "0"-Zustand, der beispielsweise lediglich 15 % beträgt. Mit anderen Worten, durch diese Gegebenheiten wird eine sichere Detektion des Inhalts einer Speicherzelle erheblich erschwert oder sogar unmöglich gemacht.

Bei von MRAMs abweichenden, anderen Speichertypen erfolgt die Detektion einer "1" oder einer "0" aus einem Strom- oder Spannungs-Lesesignal dadurch, daß dieses Lesesignal entweder mit einem Referenzstrom oder einer Referenzspannung verglichen wird, die in der Mitte zwischen dem Lesestrom bzw. einer Lesespannung für eine "1" und dem Lesestrom bzw. der Lesespannung für eine "0" liegen sollte, um so für beide digitalen Werte jeweils den besten Störabstand zu erreichen. Dieser Referenzstrom bzw. diese Referenzspannung kann über Referenzquellen oder aber auch über Referenzzellen, in die fest eine "1" und eine "0" eingeschrieben wurde, erzeugt werden.

Ein solches Vorgehen ist aber allenfalls eingeschränkt, wenn überhaupt, zur Detektion des Lesesignales bei einer MTJ-Zelle einsetzbar, was auf die eingangs geschilderte starke Schwankung des Tunnelwiderstandes von Speicherzelle zu Speicherzelle und über dem gesamten Wafer zurückzuführen ist.

Zur Lösung der oben aufgezeigten Problematik gibt es bisher lediglich zwei Ansätze:

Ein erster Ansatz (vgl. hierzu R. Scheuerlein e.a. "A 10ns Read and Write Time Non-volatile Memory Array Using a Magnetic Tunnel Junction and FET-Switch in each Cell", ISSCC Feb. 2000, S. 128) eignet sich für MTJ-Zellen mit Schalttransistor (vgl. Fig. 7c) und besteht darin, zwei benachbarte Komplementär-Speicherzellen zur Speicherung nur eines Zellinhaltes zu verwenden, wobei immer der Speicherinhalt in die erste Speicherzelle und das Komplement des Speicherinhalts, also der negierte Speicherinhalt, in die zweite Speicherzelle eingeschrieben wird. Beim Auslesen werden beide Speicherzellen gelesen und die Inhalte detektiert. Das Lesesignal und der Störabstand sind hier doppelt so groß wie beim oben erläuterten, üblichen Referenzverfahren. Allerdings sind auch der Platzbedarf und der Technologieaufwand für zwei Speicherzellen und zwei Schalttransistoren sehr groß, und es muß sichergestellt sein, daß die Widerstandsschwankungen zwischen den beiden benachbarten Komplementärzellen so klein sind, daß eine sichere Detektion erfolgen kann.

Diese Voraussetzung ist bei dem zweiten Ansatz, der auf einer Selbstreferenzierung einer gelesenen reinen MTJ-Speicherzelle (vgl. Fig. 7a) beruht, nicht erforderlich. Hierbei wird wie folgt vorgegangen:

Zunächst wird der Zellinhalt einer ausgewählten Speicherzelle ausgelesen und abgespeichert. Sodann wird in diese Speicherzelle beispielsweise eine "0" einprogrammiert. Der Inhalt der einprogrammierten "0" der Speicherzelle wird anschließend ausgelesen und abgespeichert. Der zuerst abgespeicherte Zellinhalt wird mit der abgespeicherten bekannten "0" verglichen und detektiert, und der so detektierte Zellinhalt wird wieder in die Speicherzelle zurückgeschrieben.

Nachteilhaft an einem solchen Vorgehen ist nun, daß bei der Detektion des Lesesignales zu der als Referenz einprogrammierten und wiederausgelesenen "0" ein vordefiniertes halbes Lesesignal hinzugefügt werden muß, wodurch erneut Widerstandsschwankungen Eingang in die Detektion der Speicherzelle finden.

Um nun völlig unabhängig von Widerstandsschwankungen der Speicherzellen zu sein, muß bei dem zweiten Ansatz das soeben erläuterte Verfahren durch das Einschreiben einer "1" vervollständigt werden. Es liegt dann folgender Verfahrensablauf vor:

(a) Der Zellinhalt einer ausgewählten Speicherzelle wird gelesen und abgespeichert.

(b) In die Speicherzelle wird beispielsweise eine "0" einprogrammiert.

(c) Der Inhalt der einprogrammierten "0" der Speicherzelle wird gelesen und abgespeichert.

(d) In die Speicherzelle wird eine "1" einprogrammiert.

(e) Der Inhalt der einprogrammierten "1" der Speicherzelle wird gelesen und abgespeichert.

(f) Der abgespeicherte Zellinhalt aus (a) wird mit der abgespeicherten Größe "1" und "0" aus (c) und (e) verglichen und detektiert, was durch Bildung einer Referenzspannung Vref aus der bekannten "0" und "1" erfolgt, wobei zum Detektieren der gelesenen "1" oder "0" jeweils nur die halbe Lesesignaldifferenz zur Verfügung steht, wie dies für eine gelesene "0" in Fig. 8a und für eine gelesene "1" in Fig. 8b angedeutet ist.

(g) Der detektierte Zellinhalt wird schließlich wieder in die Speicherzelle zurückgeschrieben.

Das Verfahren gemäß dem zweiten Ansatz erzeugt durch die eingeschriebenen und gelesenen "1" und "0" die Referenzspannung in der ausgewählten Speicherzelle selbst, so daß Widerstandsschwankungen von Speicherzelle zu Speicherzelle keinen Einfluß auf die Detektion haben. Der Störabstand einer "1" oder einer "0" ist aber nur halb so groß wie bei dem zuerst beschriebenen Verfahren der Komplementärzellen nach dem ersten Ansatz. Der erhebliche Nachteil des Verfahrens nach dem zweiten Ansatz liegt darin, daß insgesamt drei Lesezyklen und drei Schreibzyklen sowie ein Bewertungszyklus erforderlich sind, wodurch der Lesevorgang sehr langsam wird.

Zusammenfassend kann also festgestellt werden, daß beim ersten Ansatz der doppelte Platzbedarf und zwischen benachbarten Speicherzellen geringe Widerstandsschwankungen erforderlich sind, während der zweite Ansatz mit insgesamt sieben Zyklen einen erheblichen Zeitaufwand für einen Lesevorgang verlangt.

In DE 100 36 140 A1 (ältere Anmeldung 100 36 140.4) ist ein neuartiges Verfahren zum zerstörungsfreien Auslesen von Speicherzellen eines MRAMs beschrieben, das bei geringem Platzbedarf für jeden Lesevorgang weniger Zeit erfordert.

Dieses neuartige Verfahren umfaßt insbesondere die folgenden Verfahrensschritte:

(a) Bestimmen eines Normwiderstandswertes Rnorm einer Speicherzelle bei einer Spannung, bei der der Widerstandswert der Speicherzelle unabhängig von deren Zellinhalt ist,

(b) Bestimmen des tatsächlichen Widerstandswertes R(0) bzw. R(1) der Speicherzelle bei einer Spannung, bei der der Widerstandswert der Speicherzelle von deren Zellinhalt abhängig ist,

(c) Normieren des tatsächlichen Widerstandswertes mittels des Normwiderstandswertes durch Bilden von

$$Rnorm(0) = R(0)/Rnorm \text{ bzw.}$$

$$Rnorm(1) = R(1)/Rnorm,$$

(d) Vergleichen von Rnorm(0) bzw. Rnorm(1) mit einem normierten Referenzwiderstand

$$Rnormref = (Rnorm(0)ref + Rnorm(1)ref)/2 \text{ und}$$

(e) Detektieren des Speicherzelleninhalts als 0 oder 1 abhängig von dem Vergleichsergebnis.

Bei diesem Verfahren wird so eine Eigenschaft von MTJ-Speicherzellen ausgenutzt, die bisher noch kaum beachtet wurde. Der Widerstandswert des Tunnelwiderstandes einer Speicherzelle ist nämlich von der an dieser anliegenden Spannung abhängig. Dabei gibt es Spannungsbereiche, in denen der Tunnelwiderstand unabhängig von den Richtungen der Polarisierungen in den beiden magnetisierten Schichten die gleiche Größe hat, also für "1" und "0" gleich groß ist. In anderen Spannungsbereichen ist dagegen bei antiparalleler Orientierung der Polarisation in den beiden magnetisierten Schichten der Widerstand um ΔR größer als bei paralleler Orientierung der Polarisation in diesen Schichten, so daß hier bei dieser Spannung der Zellinhalt nach "0" und "1" unterschieden werden kann.

Das neuartige Verfahren beruht nun darauf, daß in dem zuerst genannten Spannungsbereich, der mit U1 bezeichnet werden soll, der Widerstand $R_C$ der Speicherzelle unabhängig von deren Inhalt bestimmt werden kann, während in dem an zweiter Stelle genannten Spannungsbereich, der mit U2 angegeben werden soll, dieser Widerstand $R_C$ abhängig vom Zellinhalt detektierbar ist. Es ist damit möglich, den vom Zellinhalt abhängigen Widerstand $R_C(U2)$ mittels des vom Zellinhalt unabhängigen Widerstand $R_C(U1)$ so zu normieren, daß die Inhalte verschiedener Speicherzellen, die nicht benachbart sein müssen, wieder miteinander verglichen werden können. Damit ist es auch möglich, das normierte Lesesignal einer adressierten Speicherzelle mit einem normierten Referenzsignal einer Referenzzelle, die immer jeweils mit einer "0" bzw. einer "1" beschrieben wird, zu vergleichen und damit den Inhalt der Speicherzelle als "1" oder "0" zu detektieren.

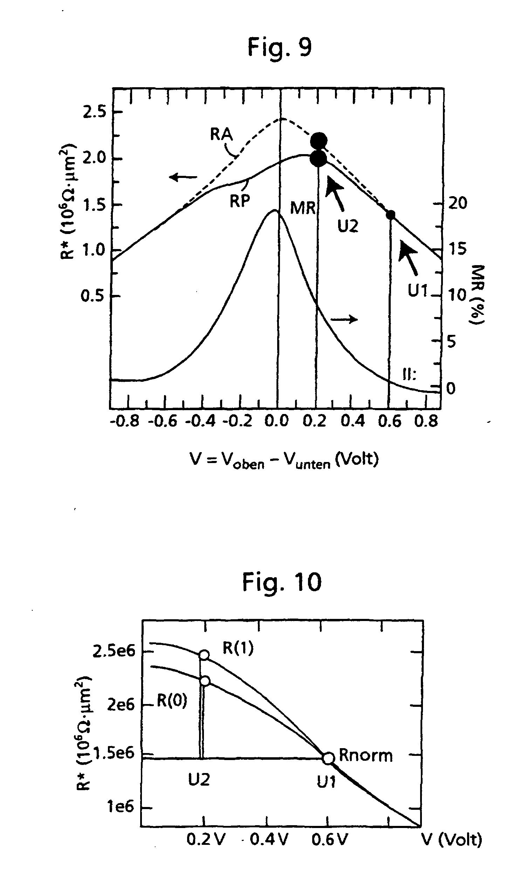

Fig. 9 zeigt den Flächenwiderstandswert R* des Tunnelwiderstandes einer Speicherzelle in Abhängigkeit von der an die Speicherzelle angelegten Spannung $V = V_{oben} - V_{unten}$, wobei $V_{oben}$ beispielsweise an der Bitleitung BL und $V_{unten}$ an der Wortleitung WL (vgl. Fig. 5) anliegen. In einem Spannungsbereich zwischen etwa -0,6 V und +0,6 V ist der Widerstandswert RA bei antiparalleler Polarisation der magnetisierten Schichten größer als der Widerstandswert RP bei deren paralleler Polarisation. Dagegen ist in Spannungsbereichen zwischen -1,0 V und -0,6 V und zwischen 0,6 V und 1,0 V der Widerstandswert für antiparallele Polarisation und parallele Polarisation der magnetisierten Schichten ungefähr gleich groß. Für eine Spannung U2 = 0,2 V ist also RA größer als RP, während für eine Spannung U1 = 0,6 V ungefähr RP (U1) = RA (U1) gilt. Für U2 gilt dagegen RA (U2) = RP (U2) + $\Delta$R.

Eine Kurve MR = (RA - RP)/RP verdeutlicht den obigen, auf der Differenz der Widerstandswerte RA und RP beruhenden Effekt.

Mit anderen Worten, bei der Spannung U2 ist es möglich, den Inhalt einer Speicherzelle zu detektieren, während bei Anlegen der Spannung U1 ein für parallele und antiparallele Polarisation der magnetisierten Schichten gleicher Widerstandswert erhalten wird, der zur Normierung des Widerstandswertes der Speicherzelle herangezogen werden kann.

Das neuartige Verfahren beruht nun grundsätzlich darauf, daß bei der Spannung U1 der Widerstandswert $R_C$(U1) der Speicherzelle unabhängig vom Zellinhalt bestimmt werden kann, während bei der Spannung U2 der Widerstandswert $R_C$(U2) der Speicherzelle abhängig vom Zellinhalt detektierbar ist. Hierdurch ist es möglich, den vom Zellinhalt abhängigen Widerstand $R_C$(U2) mittels des vom Zellinhalt unabhängigen Widerstandes $R_C$(U1) zu normieren, also $R_C$(U2)/$R_C$(U1) zu bilden, so daß der Zellinhalt verschiedener Speicherzellen, die nicht benachbart zueinander sein müssen, wieder miteinander verglichen werden kann. Mit dem neuartigen Verfahren ist es also möglich, das normierte Lesesignal einer adressierten Speicherzelle mit normierten Referenzsignalen von beispielsweise Referenzspeicherzellen zu vergleichen, die immer jeweils mit einer "0" und einer "1" beschrieben sind, so daß der Zellinhalt der adressierten Speicherzelle als "1" oder "0" detektiert werden kann.

Dieser Vorgang soll anhand von Fig. 10, in welcher wieder der Flächenwiderstand R* in Abhängigkeit von der Kontaktspannung V aufgetragen ist, nochmals näher erläutert werden.

Zunächst wird der Normwiderstandswert Rnorm bei beispielsweise der Spannung U1 = 0,6 V ermittelt und abgespeichert. Sodann wird bei der Spannung U2 = 0,2 V der Zellinhalt mit dem Widerstandswert R(0) bzw. R(1) abhängig von der antiparallelen (R(1)) bzw. parallelen (R(0)) Polarisation der magnetisierten Schichten festgelegt. Es folgt dann die Normierung von R(0) bzw. R(1) auf Rnorm, d.h. es werden Rnorm(0) = R(0)/Rnorm bzw. Rnorm(1) = R(1)/Rnorm gebildet. Es schließt sich ein Vergleich von Rnorm(0) bzw. Rnorm(1) mit einem Referenzwiderstandswert Rnormref = (Rnorm(0)ref + Rnorm(1)ref)/2 einer Referenzspeicherzelle an, welcher zuvor festgelegt wurde. Schließlich wird der Zellinhalt als "0" oder "1" als Ergebnis dieses Vergleiches detektiert.

Damit ermöglicht das neuartige Verfahren speziell die folgenden Vorteile:

Es läßt sich unabhängig von der Streuung von Widerstandswerten von Speicherzellen durchführen. Sein Ablauf erfordert lediglich zwei Zeitschritte. Durch die Normierung des Lesesignals wird ein Vergleich mit externen Referenzsignalen möglich. Es ist somit den bestehenden, eingangs erläuterten Verfahren in jeder Hinsicht überlegen. Schließlich kann das neuartige Verfahren auf alle Typen der verschiedenen MTJ-Speicherzellen, also auf reine MTJ-Speicherzellen, auf MTJ-Speicherzellen mit Dioden und MTJ-Speicherzellen mit Transistoren angewandt werden.

Es ist nun Aufgabe der vorliegenden Erfindung, eine Schaltungsanordnung zum zerstörungsfreien, selbstnormierenden Auslesen von MRAM-Speicherzellen zu schaffen, welche bei einem einfachen Aufbau und ohne großen Aufwand eine Normierung eines Lesesignals erlaubt.

Diese Aufgabe wird bei einem MRAM Speicher mit einer Schaltungsanordnung der eingangs genannten Art erfindungsgemäß durch die im kennzeichnenden Teil des Patentanspruches 1 angegebenen Merkmale gelöst.

Vorteilhafte Weiterbildungen der Erfindung ergeben sich aus den Unteransprüchen.

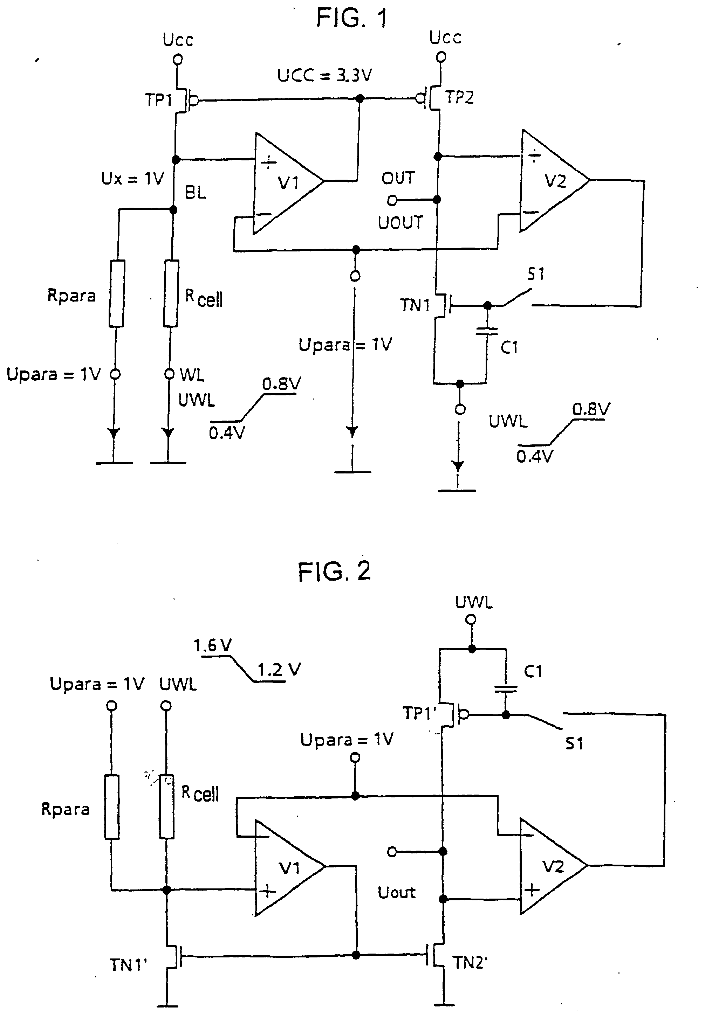

Bei der erfindungsgemäßen Schaltungsanordnung ist also die Speicherzelle an einen Stromspiegel angeschlossen, der den beim Bestimmen des Normwiderstandswertes Rnorm fließenden Strom in einen wenigstens eine Kapazität aufweisenden Zweig spiegelt, so dass nach Abschalten eines Schalters S1 (vgl. Fig. 1) durch die Kapazität und einen Transistor TN1 der Normwiderstandswert zwischenspeicherbar ist, und der den beim Bestimmen des tatsächlichen Widerstandswertes fließenden Strom Izelle (0, 1) in den Zweig fließen läßt, wodurch an einem Ausgang eine normierte Ausgangsspannung Uout (0, 1) = Rnorm · Izelle (0, 1) + $U_{WL(Lese)}$ erhalten wird ($U_{WL(Lese)}$ = 0,8 V, an Wortleitung gelesene Spannung).

Bei der erfindungsgemäßen Schaltungsanordnung wird so der beim Bestimmen des Normwiderstandswertes Rnorm fließende Strom Inorm herangezogen, um den Strom Izelle (0) bzw. Izelle (1) zu normieren und die normierte Ausgangsspannung Uout (0) bzw. Uout (1) zu erhalten, die dann mit einer normierten Referenzspannung Uref verglichen wird, um den Zellinhalt als "0" oder "1" zu detektieren. Dieses Vorgehen mit Normierung der Ströme ist möglich, da die Widerstände direkt proportional zu den Strömen sind und dadurch die Normierung erhalten bleibt.

Nachfolgend wird die Erfindung anhand der Zeichnungen näher erläutert. Es zeigen:

Fig. 1 ein schematisches Schaltbild eines ersten Ausführungsbeispiels der erfindungsgemäßen Schaltungsanordnung mit p-MOS-Feldeffekttransistoren,

Fig. 2 ein schematisches Schaltbild eines zweiten Ausführungsbeispiels der erfindungsgemäßen Schaltungsanordnung mit n-MOS-Feldeffekttransistoren,

Fig. 3 ein Schaltbild zur Erläuterung der Referenzierung eines normierten Lesesignales mittels normierter Referenzsignale für "1" und "0",

Fig. 4 ein schematisches Schaltbild zur Erläuterung einer selbstnormierten Detektion eines Zellsignales,

Fig. 5 eine schematische Darstellung einer MTJ-Speicherzelle mit einem Ersatzschaltbild,

Fig. 6 eine schematische Darstellung der Zellarchitektur für eine MTJ-Speicherzelle,

Fig. 7A bis 7C Ersatzschaltbilder einer MTJ-Speicherzelle, einer MTJ-Speicherzelle mit einer Diode und einer MTJ-Speicherzelle mit einem Transistor,

Fig. 8A und 8B schematische Darstellungen zur Erläuterung der Detektion einer "0" und einer "1" bei einem herkömmlichen Verfahren,

Fig. 9 die Abhängigkeit des Tunnelwiderstandes für parallele (RP) und antiparallele (RA) Polarisation der magnetisierten Schichten einer Speicherzelle in Abhängigkeit von der an die Speicherzelle angelegten Spannung $V = V_{oben} - V_{unten}$ in Kurven I bzw. das Widerstandsverhältnis $MR = (RA - RP)/RP$ in einer Kurve II und

Fig. 10 eine schematische Darstellung zur weiteren Erläuterung der Abhängigkeit des Widerstandes einer Speicherzelle von der über der Speicherzelle liegenden Spannung, wobei hier der Flächenwiderstand in Abhängigkeit von der Kontaktspannung aufgetragen ist.

Die Fig. 5 bis 10 sind bereits eingangs erläutert worden.

In den Figuren werden einander entsprechende Bauteile jeweils mit den gleichen Bezugszeichen versehen.

Fig. 1 zeigt eine durch einen Widerstand Rzelle (oben auch $R_C$ genannt) symbolisierte MTJ-Speicherzelle, die hier in Reihe mit einem p-MOS-Feldeffekttransistor TP1 zwischen einer Bitleitung BL und einer Wortleitung WL mit einer Wortleitungsspannung UWL, die beispielsweise 0,4 V und 0,8 V betragen kann, liegt.

Es wird hier davon ausgegangen, dass die Speicherzelle Rzelle eine adressierte MTJ-Speicherzelle eines Speicherzellenfeldes ist. Für dessen übrigen Speicherzellen gelten entsprechende Überlegungen.

Ein Widerstand Rpara, der parallel zur Speicherzelle mit dem Widerstand Rzelle liegt, soll die parasitären Widerstände der anderen Speicherzellen symbolisieren, welche an der Bitleitung BL liegen.

Ein Differenzverstärker V1 ist mit seinem positiven Eingang (+) mit einem Verbindungspunkt zwischen dem Transistor TP1 und der Speicherzelle Rzelle verbunden und liegt mit seinem negativen Eingang (-) an einer Spannung Upara von beispielsweise 1 V und am negativen Eingang (-) eines weiteren Differenzverstärkers V2. Der Ausgang des Differenzverstärkers V1 ist mit Gate des Transistors TP1 und Gate eines p-MOS-Feldeffekttransistors TP2 verbunden, an dessen Source eine Spannung UCC von beispielsweise 3,3 V anliegt. Drain des Transistors TP2 ist mit dem negativen Eingang (-) des weiteren Differenzverstärkers V2, einem Ausgang OUT und Drain eines n-MOS-Feldeffekttransistors TN1 verbunden, dessen Source an der Wortleitungsspannung UWL liegt und über einen Kondensator C1 mit dessen Gate verbunden ist. Der Ausgang des weiteren Differenzverstärkers V2 ist über einen Schalter S1 an Gate des Transistors TN1 angeschlossen.

Am negativen Eingang (-) des Differenzverstärkers V1 soll beispielsweise eine Spannung Upara von 1 V plus einer Spannung für eine "offset"-Kompensation anliegen, so dass zwischen dem positiven Eingang (+) des Differenzverstärkers V1, der mit einer Spannung Ux = 1 V beaufschlagt ist, und dem negativen Eingang (-) dieses Differenzverstärkers V1 annähernd 0 V abfallen. Der Rest der Leitungen des Zellenfeldes soll ebenfalls auf beispielsweise Upara = 1 V liegen.

Die angegebenen Spannungswerte sind selbstverständlich lediglich Beispiele und können tatsächlich von diesen, abhängig von der verwendeten Technologie, ohne weiteres abweichen. Es soll lediglich vorausgesetzt werden, dass der Differenzverstärker V1 offset-kompensiert ist.

Zunächst liegt die Wortleitungsspannung UWL auf 0,4 V. Die Spannung über der Speicherzelle Rzelle beträgt dann Uzelle = U1 = 1 V - 0,4 V = 0,6 V. Dabei ist der Schalter S1 geschlossen. Der Differenzverstärker V1 regelt den Transistor TP1 dann so, dass der Strom durch die Speicherzelle dem Strom durch den Transistor TP1 und dem Strom durch den Transistor TP2 entspricht.

Da an der Speicherzelle Rzelle 0,6 V anliegen, entspricht der durch die Speicherzelle fließende Strom Izelle dem Normstrom Inorm (vgl. hierzu auch Fig. 9). Dies bedeutet, dass der Widerstandswert der Speicherzelle Rzelle für die Spannung Uzelle = 0,6 V die Größe Rnorm = Uzelle/Inorm annimmt.

Wird sodann der Schalter S1 geöffnet, so wird der Widerstandswert Rnorm mittels des Kondensators C1 auf dem Transistor TN1 abgespeichert.

Es sei angenommen, dass sodann die Wortleitungsspannung UWL auf 0,8 V geht und der Schalter S1 offen bleibt. Die Spannung Uzelle über der Speicherzelle Rzelle ist sodann durch Uzelle = U1 = 1 V - 0,8 V = 0,2 V gegeben. Bei dieser Spannung hängt der Widerstandswert der Speicherzelle Rzelle von den Magnetisierungsrichtungen in den einzelnen magnetisierten Schichten ML1 und ML2 ab (vgl. Fig. 9 und 10). Der Differenzverstärker V1 regelt den Transistor TP1 so, dass der Strom Izelle dem Strom durch den Transistor TP1 und damit auch dem Strom durch den Transistor TP2 entspricht.

Der Widerstandswert der Speicherzelle Rzelle bei der Spannung Uzelle = 0,2 V hat nun abhängig von der parallelen oder antiparallelen Magnetisierung den Wert R(0) oder den Wert R(1). Mit anderen Worten, es gilt Rzelle (Uzelle = 0,2 V) = R(0, 1).

Am Ausgang OUT wird nun die Ausgangsspannung Uout (0, 1) = Rnorm · Izelle (0, 1) = (Uzelle/Inorm) · Izelle (0, 1) erhalten.

Schließlich wird noch die Ausgangsspannung Uout (0, 1) mit einer normierten Referenzspannung mittels eines Komparators verglichen und als "1"- oder "0"-Signal detektiert. Diese Referenzspannung kann von einer Referenzquelle oder einer Referenzzelle abgeleitet sein.

Die Schaltungsanordnung des Ausführungsbeispiels von Fig. 1 kann ohne weiteres auch in komplementärer Form aufgebaut sein und anstelle der p-MOS-Feldeffekttransistoren TP1 und TP2 n-MOS-Feldeffekttransistoren TN1' und TN2' verwenden, wobei dann der n-MOS-Transistor TN1 des Beispiels von Fig. 1 durch einen p-MOS-Feldeffekttransistor TP1' ersetzt ist. Eine entsprechende Schaltungsanordnung ist in Fig. 2 gezeigt.

Das Ausführungsbeispiel von Fig. 2 arbeitet in analoger Weise wie das Ausführungsbeispiel von Fig. 1, so dass ergänzend nur auf folgendes hingewiesen sein soll:

Der Normwiderstand Rnorm wird im Beispiel von Fig. 2 durch den Transistor TP1' auf den Kondensator C1 abgebildet. Über der Speicherzelle Rzelle fällt wie im Ausführungsbeispiel von Fig. 1 eine Spannung von 0,6 V und 0,2 V ab, indem für die Wortleitungsspannung UWL Werte von 1,6 V und 1,2 V angenommen werden.

Das Ausführungsbeispiel von Fig. 2 kann bei Verwendung entsprechender Differenzverstärker V1 und V2 besonders vorteilhaft sein.

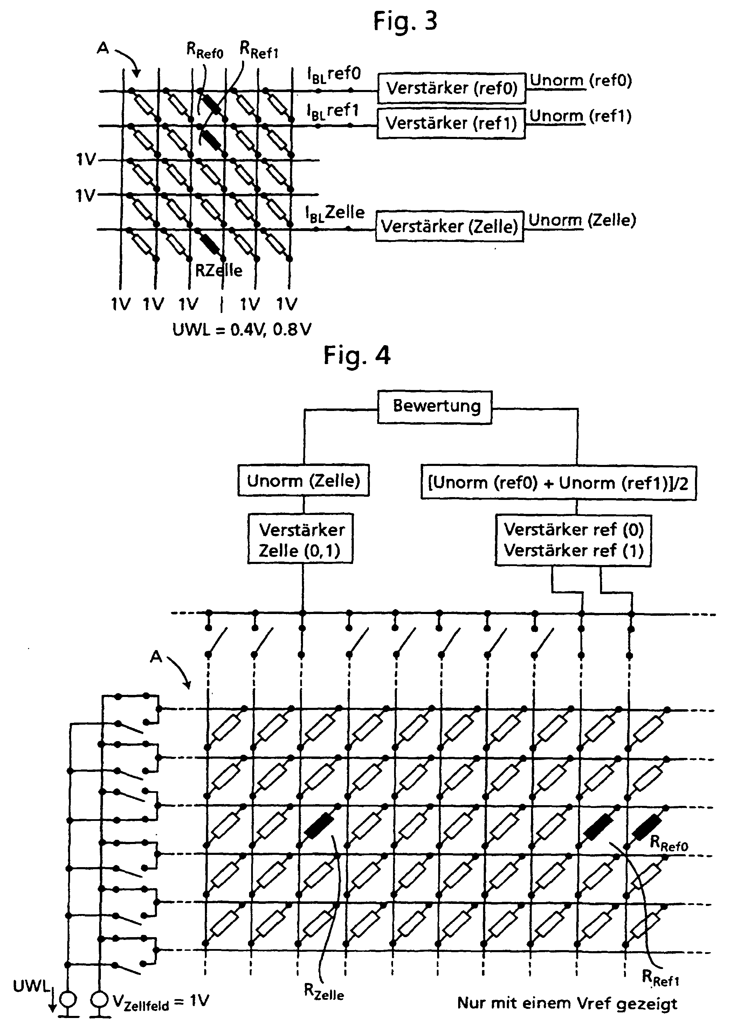

Fig. 3 zeigt ein Beispiel einer Schaltungsanordnung für eine mögliche Referenzierung eines Lesesignales mit Hilfe von Referenzzellen $R_{Ref0}$ und $R_{Ref1}$, in welche jeweils eine "0" und eine "1" fest eingeschrieben sind. Hierbei werden an die Referenzzelle $R_{Ref1}$, in die zuvor eine "1" eingeschrieben wurde, und an die Referenzzelle $R_{Ref0}$, in die zuvor eine "0" eingeschrieben wurde, die gleiche Spannung UWL wie an die auszulesende Zelle $R_{Zelle}$ gelegt. Dabei sind die Referenzzellen $R_{Ref0}$ und $R_{Ref1}$ und die auszulesende Zelle $R_{Zelle}$ jeweils mit einem Verstärker "Verstärker(refl)", einem Verstärker "Verstärker(ref0)" und einem Verstärker "Verstärker(Zelle)" verbunden, um jeweils ein normiertes Signal Unorm(ref1), Unorm(ref0) und Unorm(Zelle) zu generieren, das gegeben ist durch Unorm(ref1) = 1 V + (UBL - UWL) (Rnorm1/Rref1),
Unorm(ref0) = 1 V + (UBL - UWL) (Rnorm0/Rref0) und Unorm(Zelle) = 1 V + (UBL - UWL) (Rnormzelle/Rrefzelle). Durch Vergleich des normierten Zellsignales mit dem aus den normierten Referenzzellsignalen Unorm(ref0) und Unorm(ref1) gewonnenen Referenzsignal Unormref = (Unorm(ref0) + Unorm(ref1))/2 kann dann, wie in Fig. 4 gezeigt ist, in einem Bewertungsschritt der Zellinhalt der Zelle Rzelle im Speicherfeld A detektiert werden.

Bezugszeichenliste

| | |
|---|---|
| RA | Widerstandswert der Speicherzelle bei antiparalleler Magnetisierung der magnetisierten Schichten |
| RP | Widerstandswert der Speicherzelle bei paralleler Magnetisierung der magnetisierten Schichten |
| MR | Widerstandsverhältnis |
| R* | Flächenwiderstand der Speicherzelle |
| R(0) | Widerstandswert der Speicherzelle bei paralleler Magnetisierung der magnetisierten Schichten |
| R(1) | Widerstandswert der Speicherzelle bei antiparalleler Magnetisierung der magnetisierten Schichten |
| Rnorm | Normwiderstandswert |
| U1 | Spannung, bei der Widerstandswert von Speicherinhalt unabhängig ist |
| U2 | Spannung, bei der Widerstandswert von Speicherinhalt abhängig ist |
| V1, V2 | Differenzverstärker |
| Rpara | parasitäre Widerstände anderer Speicherzellen |

Rzelle       Widerstandswert der Speicherzelle
S1       Schalter
UWL       Spannung auf Wortleitung WL
Uout       Ausgangsspannung
OUT       Ausgangsanschluß
A       Speicherzellenfeld
BL       Bitleitung
WL       Wortleitung
TL       nichtmagnetische Zwischenschicht
ML1       erste magnetisierte Schicht
ML2       zweite magnetisierte Schicht
$R_C$       Ersatzwiderstand für Speicherzelle
$I_{WL}$       Wortleitungsstrom
$I_{BL}$       Bitleitungsstrom
T       Transistor
D       Diode
TN1, TN1'       n-MOS-Feldeffekttransistor
TN2, TN2'       n-MOS-Feldeffekttransistor
TP1, TP1'       p-MOS-Feldeffekttransistor
TP2       p-MOS-Feldeffekttransistor

**Patentansprüche**

1. MRAM Speicher mit einer Schaltungsanordnung zum zerstörungsfreien, selbstnormierenden Auslesen von MRAM-Speicherzellen, bei der ein Normwiderstandswert Rnorm einer Speicherzelle bei einer Spannung, bei der der Widerstandswert der Speicherzelle unabhängig von deren Zellinhalt ist, und der tatsächliche Widerstandswert R(0) bzw. R(1) der Speicherzelle bei einer Spannung, bei der der Widerstandswert der Speicherzelle von deren Zellinhalt abhängig ist, bestimmt werden, bei der sodann der tatsächliche Widerstandswert mittels des Normwiderstandswertes durch Bilden von

$$Rnorm(0) = R(0)/Rnorm \text{ bzw.}$$

$$Rnorm(1) = R(1)/Rnorm$$

normiert und Rnorm(0) bzw. Rnorm(1) mit einem Referenzwert verglichen wird und bei der schließlich der Speicherzelleninhalt als 0 oder 1 abhängig von dem Vergleichsergebnis detektiert wird, **dadurch gekennzeichnet,** **dass** die Speicherzelle (Rzelle) an einen Stromspiegel (TP1, TP2, Rzelle, TN1) angeschlossen ist, der den beim Bestimmen des Normwiderstandswertes Rnorm fließenden Strom in einen wenigstens eine Kapazität (C1) aufweisenden Zweig spiegelt, so dass nach Öffnen eines Schalters (S1) durch die Kapazität (C1) und einen Transistor (TN1) der Normwiderstandswert zwischenspeicherbar ist, und der den beim Bestimmen des tatsächlichen Widerstandswertes fließenden Strom Izelle(0, 1) in dem Zweig fließen läßt, so dass an einem Ausgang (OUT) eine normierte Ausgangsspannung Uout(0, 1) = Rnorm · Izelle(0, 1) erhalten wird.

2. MRAM Speicher nach Anspruch 1, **dadurch gekennzeichnet,** **dass** eine Reihenschaltung aus der Speicherzelle (Rzelle) und einem Transistor (TP1) eines ersten Leitungstyps zwischen einer Wortleitung (WL) und einer Bitleitung (BL) liegen.

3. MRAM Speicher nach Anspruch 1 oder 2, **dadurch gekennzeichnet ,** **dass** in dem die Kapazität (T1) enthaltenden Zweig eine Reihenschaltung aus einem Transistor (TP2) des einen Leitungstyps und einem Transistor (TN1) des anderen Leitungstyps zwischen einer Wortleitungsspannung (UWL) und einer Versorgungsspannung (UCC) liegen.

4. MRAM Speicher nach Anspruch 3, **dadurch gekennzeichnet,** **dass** die Gates des mit der Speicherzelle (Rzelle) in Reihe liegenden Transistors (TP1) des einen Leitungstyps und des Transistors (TP2) des einen Leitungstyps in dem die Kapazität (C1) enthaltenden Zweig miteinander verbunden sind.

5. MRAM Speicher nach Anspruch 4, **dadurch gekennzeichnet,** **dass** ein Verbindungspunkt zwischen der Speicherzelle (Rzelle) und dem mit diesem in Reihe liegenden Transistor (TP1) an den positiven Eingang (+) eines ersten Verstärkers (V1) angeschlossen ist.

6. MRAM Speicher nach Anspruch 5, **dadurch gekennzeichnet,** **dass** der negative Eingang (-) des ersten Verstärkers (V1) und ein erster Eingang (-) eines zweiten Verstärkers (V2) sowie der positive Anschluß eine Spannungsquelle (Upara) miteinander verbunden sind.

7. MRAM Speicher nach Anspruch 6, **dadurch gekennzeichnet** **dass** der Ausgang des ersten Verstärkers (V1) an einen Verbindungspunkt der über ihre Gates miteinander verbundenen Transistoren (TP1, TP2) angeschlossen ist.

8. MRAM Speicher nach Anspruch 7, **dadurch gekennzeichnet,** **dass** der zweite Eingang des zweiten Verstärkers (V2) mit einem Verbindungspunkt der beiden Transistoren (TP2, TN1) des die Kapazität (C1) enthaltenden Zweiges verbunden ist.

9. MRAM Speicher nach Anspruch 8,

**dadurch gekennzeichnet,**
**dass** der Ausgang des zweiten Verstärkers (V2) über einen Schalter (S1) an einen Verbindungspunkt zwischen der Kapazität (C1) und Gate des Transistors (TN1) des anderen Leitungstyps in dem die Kapazität (C1) enthaltenden Zweig angeschlossen ist.

10. MRAM Speicher nach Anspruch 9,
**dadurch gekennzeichnet,**
**dass** ein Ausgang (OUT) zwischen dem Transistor (TP2) des einen Leitungstyps und dem Transistor (TN1) des anderen Leitungstyps in dem die Kapazität (C1) enthaltenden Zweig vorgesehen ist.

**Claims**

1. MRAM memory having a circuit for non-destructive, self-normalizing reading-out of MRAM memory cells, in which a normal resistance value $R_{norm}$ of a memory cell is determined at a voltage at which the resistance value of the memory cell is independent of its cell content, and the actual resistance value R(0) or R(1) of the memory cell is determined at a voltage at which the resistance value of the memory cell depends on its cell content, in which the actual resistance value is then normalized by means of the normal resistance value by forming

$$R_{norm}(0) = R(0)/R_{norm}$$

and, respectively,

$$R_{norm}(1) = R(1)/R_{norm}$$

and $R_{norm}(0)$ and $R_{norm}(1)$ are compared with a reference value, and in which, finally, the memory cell content is detected as 0 or 1 on the basis of the comparison result, **characterized in that** the memory cell ($R_{cell}$) is connected to a balanced circuit (TP1, TP2, $R_{cell}$, TN1), which mirrors the current flowing during the determination of the normal resistance value $R_{norm}$ into a branch having at least one capacitor (C1), so that after a switch (S1) has been opened, the normal resistance value can be buffered by the capacitor (C1) and a transistor (TN1), and permits the current $I_{cell}(0, 1)$ that flows during the determination of the actual resistance value to flow in the branch, so that a normalized output voltage $U_{out}(0,1) = R_{norm} \cdot I_{cell}(0,1)$ is obtained at an output (OUT).

2. MRAM memory according to Claim 1, **characterized in that** a series circuit comprising the memory cell ($R_{cell}$) and a transistor (TP1) of a first conduction type is located between a word line (WL) and a bit line (BL).

3. MRAM memory according to Claim 1 or 2, **characterized in that**, in the branch containing the capacitor (T1), a series circuit comprising a transistor (TP2) of one conduction type and a transistor (TN1) of the other conduction type is located between a word line voltage (UWL) and a supply voltage (UCC).

4. MRAM memory according to Claim 3, **characterized in that** the gates of the transistor (TP1) of the one conduction type connected in series with the memory cell ($R_{cell}$) and of the transistor (TP2) of the one conduction type in the branch containing the capacitor (C1) are connected to each other.

5. MRAM memory according to Claim 4, **characterized in that** a junction between the memory cell ($R_{cell}$) and the transistor (TP1) in series therewith is connected to the positive input (+) of a first amplifier (V1).

6. MRAM memory according to Claim 5, **characterized in that** the negative input (-) of the first amplifier (V1) and a first input (-) of a second amplifier (V2), and also the positive terminal of a voltage source ($U_{para}$) are connected to one another.

7. MRAM memory according to Claim 6, **characterized in that** the output of the first amplifier (V1) is connected to a junction between the transistors (TP1, TP2) that are connected to each other via their gates.

8. MRAM memory according to Claim 7, **characterized in that** the second input of the second amplifier (V2) is connected to a junction between the two transistors (TP2, TN1) of the branch containing the capacitor (C1).

9. MRAM memory according to Claim 8, **characterized in that** the output of the second amplifier (V2) is connected via a switch (S1) to a junction between the capacitor (C1) and the gate of the transistor (TN1) of the other conduction type in the branch containing the capacitor (C1).

10. MRAM memory according to Claim 9, **characterized in that** an output (OUT) is provided between the transistor (TP2) of the one conduction type and the transistor (TN1) of the other conduction type in the branch containing the capacitor (C1).

**Revendications**

1. Mémoire MRAM comprenant un circuit de lecture, sans destruction et auto-normant, de cellules de mémoire MRAM, dans lequel il est déterminé une valeur Rnorm normée de résistance d'une cellule de mémoire, pour une tension pour laquelle la valeur de la résistance de la cellule de mémoire est indépendante de son contenu de cellule et la valeur R(0) ou R(1) réelle de la résistance de la cellule de mémoire, pour une tension pour laquelle la valeur de la résistance de la cellule de mémoire dépend de son contenu de cellule, dans laquelle, ensuite, la valeur réelle de la résistance est normée au moyen de la valeur de norme de la résistance par formation de

$$Rnorm(0) \quad = \quad R(0)/Rnorm$$

ou

$$Rnorm(1) \quad = \quad R(1)/Rnorm$$

et Rnorm(0) ou Rnorm(1) est comparé à une valeur de référence et dans lequel, finalement, le contenu de la cellule de mémoire est détecté comme étant 0 ou 1 en fonction du résultat de la comparaison,
   **caractérisée**
   **en ce que** la cellule (Rzelle) de mémoire est raccordée à un miroir (TP1, TP2, Rzelle, TN1) qui réfléchit le courant passant lors de la détermination de la valeur Rnorm de norme de la résistance, dans une branche ayant au moins une capacité (C1), de sorte qu'après ouverture d'un interrupteur (S1), la valeur de norme de la résistance peut être mémorisée intermédiairement par la capacité (C1) et par un transistor (TN1) et qui laisse passer dans la branche le courant Izelle (0, 1) passant lors de la détermination de la valeur réelle de la résistance, de manière à obtenir sur une sortie (OUT) une tension Uout(0, 1) = Rnorm ·Izelle(0, 1) normée de sortie.

2. Mémoire MRAM suivant la revendication 1,
   **caractérisée**
   **en ce qu'**un circuit série constitué de la cellule (Rzelle) de mémoire et d'un transistor (TP1) d'un premier type de conduction se trouve entre une ligne (WL) de mot et une ligne (BL) de bit.

3. Mémoire MRAM suivant la revendication 1 ou 2,
   **caractérisée**
   **en ce qu'**il y a dans la branche contenant la capacité (T1) un circuit série constitué d'un transistor (TP2) d'un type de conductivité et un transistor (TN1) de l'autre type de conductivité entre une tension (UWL) de ligne de mot et une tension (UCC) d'alimentation.

4. Mémoire MRAM suivant la revendication 3,
   **caractérisée**
   **en ce que** les grilles du transistor (TP1) du premier type de conductivité montée en série avec la cellule (Rzelle) de mémoire et du transistor (TP2) d'un type de conductivité dans la branche contenant la capacité (C1) sont reliées ensemble.

5. Mémoire MRAM suivant la revendication 4,
   **caractérisée**
   **en ce qu'**un point de liaison compris entre la cellule (Rzelle) de mémoire et le transistor (TP1) monté en série avec celle-ci est raccordé à l'entrée (+) positive d'un premier amplificateur (V1).

6. Mémoire MRAM suivant la revendication 5,
   **caractérisée**
   **en ce que** l'entrée (-) négative du premier amplificateur (V1) et une première entrée (-) d'un deuxième amplificateur (V2) ainsi que la borne positive d'une source (Upara) de tension sont reliées entre elles.

7. Mémoire MRAM suivant la revendication 6,
   **caractérisée**
   **en ce que** la sortie du premier amplificateur (V1) est raccordée à un point de liaison des transistors (TP1, TP2) reliés entre eux par leurs grilles.

8. Mémoire MRAM suivant la revendication 7,
   **caractérisée**
   **en ce que** la deuxième entrée du deuxième amplificateur (V2) est reliée à un point de liaison des deux transistors (TP2, TN1) de la branche contenant la capacité (C1).

9. Mémoire MRAM suivant la revendication 8,
   **caractérisée**
   **en ce que** la sortie du deuxième amplificateur (V2) est raccordée par un interrupteur (S1) à un point de liaison compris entre la capacité (C1) et la grille du transistor (TN1) de l'autre type de conductivité dans la branche contenant la capacité (C1).

10. Mémoire MRAM suivant la revendication 9,
   **caractérisée**
   **en ce qu'**il est prévu une sortie (OUT) entre le transistor (TP2) du type de conductivité au transistor (TN1) de l'autre type de conductivité dans la branche contenant la capacité (C1).

# FIG. 1

# FIG. 2

# Fig. 3

$R_{Ref0}$  $R_{Ref1}$

A

$I_{BL}ref0$ — Verstärker (ref0) — Unorm (ref0)

$I_{BL}ref1$ — Verstärker (ref1) — Unorm (ref1)

1V

1V

$I_{BL}Zelle$ — Verstärker (Zelle) — Unorm (Zelle)

RZelle

1V  1V  1V  |  1V  1V

UWL = 0.4V, 0.8V

# Fig. 4

Bewertung

Unorm (Zelle)           [Unorm (ref0) + Unorm (ref1)]/2

Verstärker              Verstärker ref (0)
Zelle (0,1)             Verstärker ref (1)

A

$R_{Ref0}$

$R_{Zelle}$             $R_{Ref1}$

UWL  $V_{Zellfeld} = 1V$     $R_{Zelle}$     Nur mit einem Vref gezeigt

## Fig. 5

## Fig. 6

BL

"1"

WL

"0"

Zellinhalt

## Fig. 7a

WL

$R_C$

BL

## Fig. 7 b

WL

$R_C$

D

BL

## Fig. 7c

WL

$R_C$

BL    T

## Fig. 8 a

bekannte

"0"    "1"

gelesene

"0"    Vref

## Fig. 8 b

bekannte

gelesene

"1"    "0"    "1"

Vref

# Fig. 9

$V = V_{oben} - V_{unten}$ (Volt)

# Fig. 10